# EUROPEAN PATENT SPECIFICATION

(11) **EP 3 264 878 B1**
(45) Date of publication and mention of the grant of the patent: **27.03.2019**
(21) Application number: 15883165.1
(22) Date of filing: 24.02.2015
(51) Int. Cl.: H05K 13/04

(54) **COMPONENT MOUNTER**
KOMPONENTENMONTAGEMASCHINE
MACHINE DE MONTAGE DE COMPOSANTS

(43) Date of publication of application: 03.01.2018
(73) Proprietor: FUJI Corporation, Chiryu Aichi (JP)
(72) Inventor: NISHIYAMA, Satoru, Chiryu Aichi (JP); ITO, Akinobu, Chiryu Aichi (JP); TESHIMA, Chikashi, Chiryu Aichi (JP)
(74) Representative: Grünecker Patent- und Rechtsanwälte PartG mbB
(86) International application number: PCT/JP2015/055297
(87) International publication number: WO 2016/135869

(56) References cited:
- WO-A1-2014/033900
- WO-A1-2014/033900
- WO-A1-2015/011805
- JP-A- 2008 072 066
- KR-A- 20050 022 735

## Description

### Technical Field

The present invention relates to a component mounter that appropriately exchanges a multi-nozzle head that holds multiple suction nozzles in an exchangeable manner and a single-nozzle head that holds a single nozzle section.

### Background Art

With a component mounter disclosed in patent literature 1 (WO2014/033900), it is possible to exchangeably hold either a multi-nozzle head or a single-nozzle head on a head holding unit that is moved by a head moving device. Here, a single-nozzle head is configured such that a single nozzle section that picks up a component is formed as one on a lower section of a head main body section held on a head holding unit. Patent literature 1 discloses the preamble of claim 1.

Patent literature 2 discloses a head nozzle device of a surface mounting apparatus, which is considered as related background art.

### Citation List

### Patent Literature

Patent Literature 1: WO2014/033900
Patent Literature 2: KR 2005 0022735 A

### Summary of Invention

### Technical Problem

With the component mounter configured as above, because the holding configuration for holding the multi-nozzle head on the head holding unit and the holding configuration for holding the single-nozzle head on the head holding unit are shared, the configuration of the single-nozzle head is complicated and the size is large. Therefore, the manufacturing costs of the single-nozzle head are high, and if the quantity of single-nozzle heads with different sizes and shapes or nozzle section is increased, there is a problem of increased costs, and difficulty in meeting the need to decrease required storage space, due to the increased space needed to store the single-nozzle heads.

Therefore, to solve the above problems, an object of the present invention is to provide a component mounter for which an increased quantity of various single-nozzle heads with different sizes and shapes of nozzle section can be provided at low cost, while curtailing any increase in storage space required due to the increased quantity of various single-nozzle heads, thereby meeting the needs for low cost and reduced space.

### Solution to Problem

To solve the above problems, the present invention is a component mounter that includes: a head holding unit configured to exchangeably hold either a multi-nozzle head that is configured to exchangeably hold multiple suction nozzles that are configured to pick up
a component or a single-nozzle head that is configured to hold a single nozzle section, and a head moving device configured to move the head holding unit, wherein the single-nozzle head is configured from an attachment section that is exchangeable with the multi-nozzle head on the head holding unit, and the single nozzle section that is exchangeably held on the attachment section and picks up the component, and a holding configuration of the single nozzle section on the attachment section and a holding configuration of the suction nozzle on the multi-nozzle head are shared, such that the suction nozzle of the multi-nozzle head can be held on the attachment section of the single-nozzle head as the single nozzle section and the single nozzle section of the single-nozzle head can be held on the multi-nozzle head as one of its suction nozzles.

That is, with the present invention, a single-nozzle head is divided into an attachment section held by the head holding unit, and a nozzle section, and the holding configuration of the nozzle section on the attachment section, and the holding configuration of the suction nozzle on the multi-nozzle head are shared, therefore it is possible to use the nozzle section of the single-nozzle head as a suction nozzle of the multi-nozzle head. By this, various (different types of) single-nozzle heads with different sizes and shapes of nozzle section (suction nozzle) can be provided at low cost, thus curtailing any increase in storage space required due to the increased quantity of various single-nozzle heads, and meeting the needs for low cost and reduced space. Note that, a nozzle section used on the single-nozzle head is not restricted to a suction nozzle used on the multi-nozzle head, a nozzle section newly manufactured for single-nozzle head use may be used, that is, a suction nozzle used on the multi-nozzle head may be included in the various nozzle sections used on the single-nozzle head.

The present invention may be provided with a control device configured to control operation of the head moving device so as to attach and detach the
nozzle section or the suction nozzle to and from the attachment section held by the head holding unit. By this, it is possible to automate operation of attaching and detaching the nozzle section or the suction nozzle to and from the attachment section held on the head holding unit.

Further, the control device may control operation of the head moving device so as to attach and detach the multi-nozzle head or the attachment section to and from the head holding unit. By this, it is possible to automate exchange operation of multi-nozzle heads and the attachment section of the single-nozzle head to and from the head holding unit.

Further, the present invention may be configured such that a nozzle holder for holding the suction nozzle is lowerably held on the multi-nozzle head; an engagement protruding section is provided protruding to a side on an upper section of the suction nozzle and on an upper section of the nozzle section; an engagement groove with an inverted L shape or inverted J shape into which the engagement protruding section is inserted from below is formed in an engagement cylindrical section which engages the upper section of the suction nozzle in the nozzle holder and in an engagement cylindrical section which engages the upper section of the nozzle section in the attachment section; and a spring to maintain the state in which the respective engagement protruding sections are engaged with the respective engagement grooves is provided in the nozzle holder and the attachment section. By doing this, a suction nozzle or nozzle section can be held mechanically in a nozzle holder or attachment section by the engagement of the engagement protruding section at the suction nozzle side or the nozzle section side and the engagement groove at the nozzle holder side or the attachment section side, and positional deviation or dropping of a suction nozzle or nozzle section due to the inertia force can be prevented even if a head is moved at a high speed. Further, for the present invention, it is also acceptable for the suction nozzle or nozzle section to be held in the nozzle holder or attachment section using a plunger or plate spring.

### Brief Description of Drawings

Fig. 1 is a perspective view showing an embodiment of the present invention, in which a multi-nozzle head is shown removed from the head holding unit of the component pickup device.
Fig. 2 is a perspective view showing the R-axis section of the head holding unit.
Fig. 3 is a perspective view of a multi-nozzle head.
Fig. 4 is a front view of a single-nozzle head.
Fig. 5 is a front view showing a state in which the nozzle section (suction nozzle) is removed from the single-nozzle head.
Fig. 6 is a block diagram showing the configuration of control items of the component mounter.

### Description of Embodiments

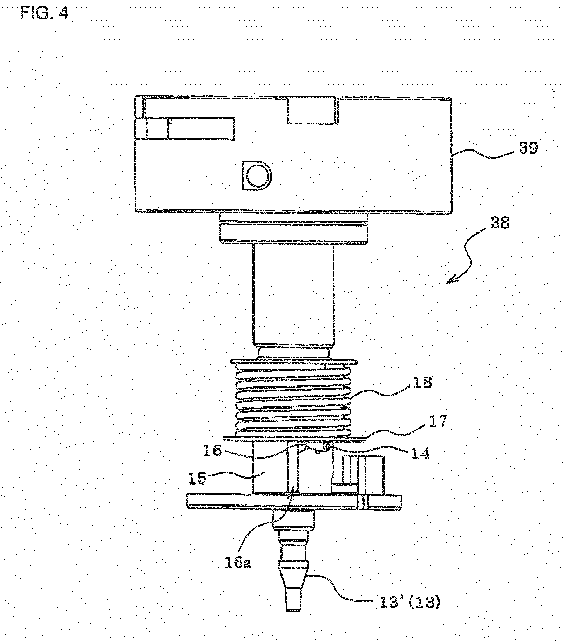

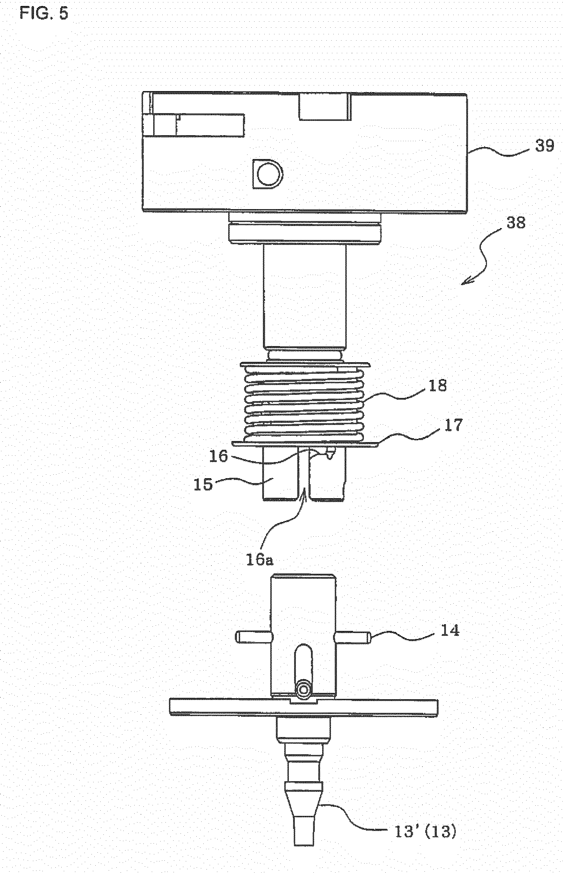

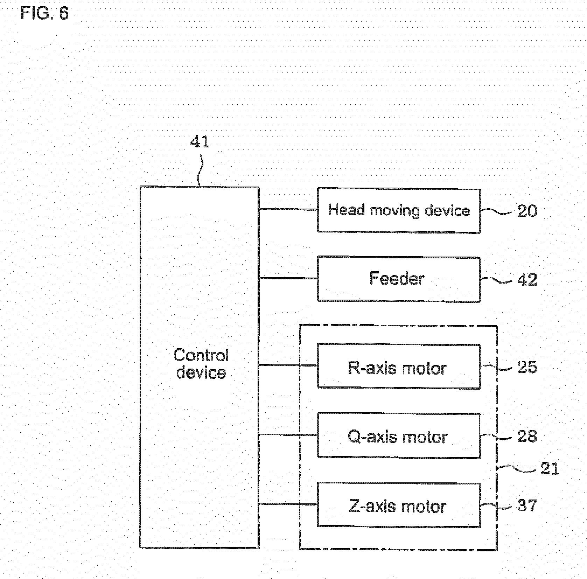

An embodiment of the invention is described below. Head moving device 20 (refer to fig. 6) that moves head holding unit 21 is XYZ directions is loaded on a component mounter. Head holding unit 21 is configured to exchangeably hold one of multi-nozzle head 11 that exchangeably (attachably and detachably) holds multiple suction nozzles 13 that pick up a component, and single-nozzle head 38 (refer to figs. 4 and 5) that holds a single nozzle section 13'.

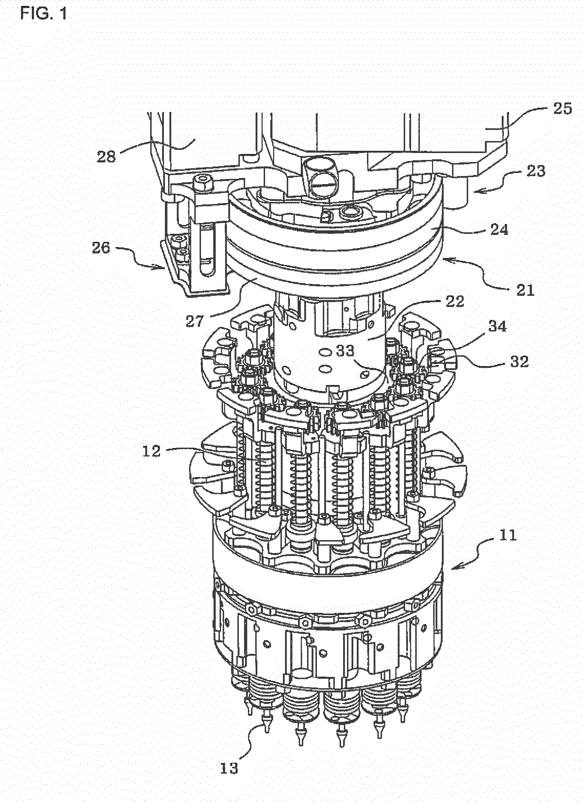

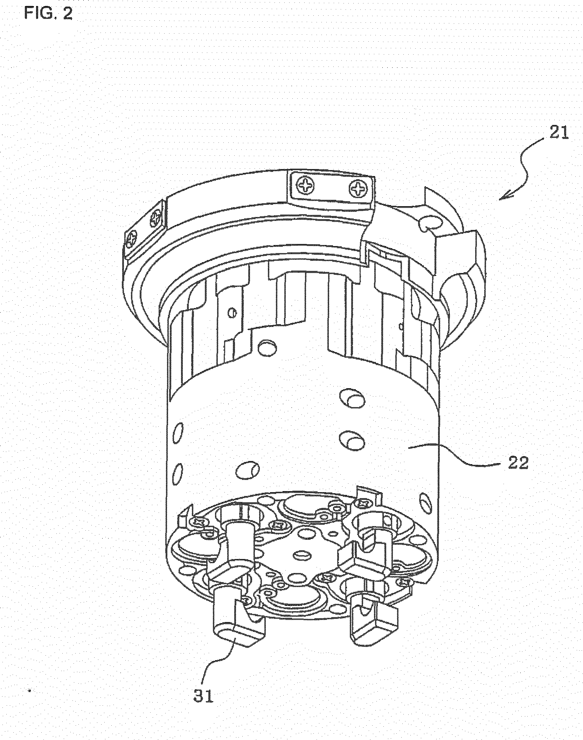

As shown in figs. 1 and 2, multi-nozzle head 11 of the embodiment is a rotary-type head (rotary head) that holds multiple nozzle holders 12 in a lowerable manner at predetermined intervals in a circumferential direction, and a suction nozzle 13 is engageably held facing downwards on a lower section of each nozzle holder 12 so as to be exchangeable (attachable and detachable).

Multi-nozzle head 11 is exchangeably held (attachable and detachable) on R axis 22 extending downwards from head holding unit 21. R-axis driving mechanism 23 (head rotating mechanism) that rotates R axis 22 is assembled on head holding unit 21. R-axis driving mechanism 23 rotates R-axis gear 24 (tooth surfaces not shown) fixed on the upper end of R axis 22 by R-axis motor 25 and rotates multi-nozzle head 11 around R axis 22, thus multiple nozzle holders 12 revolve in a circumferential direction of multi-nozzle head 11 together with multiple suction nozzles 13.

In R axis 22, Q-axis gear 27 (tooth surfaces not shown) which is a driving source of Q-axis driving mechanism 26 (nozzle rotating mechanism) is rotatably inserted through and the Q-axis gear 27 rotates around R axis 22 by Q-axis motor 28.

As shown in fig. 2, on the lower section of R axis 22, multiple (for example, four) engaging members 31 are provided movably in the up/down direction in order to detachably engage and hold multi-nozzle head 11, and close to each engaging member 31, an air cylinder (not shown) that drives each engaging member 31 in the up/down direction is provided. Each engaging member 31 is respectively formed in an L shape or J shape and arranged at even intervals in a circumferential direction of R axis 22, and the direction of the claw section of each engaging member 31 is arranged so as to be facing in the same direction as the normal rotational direction (or the reverse rotational direction) of R axis 22.

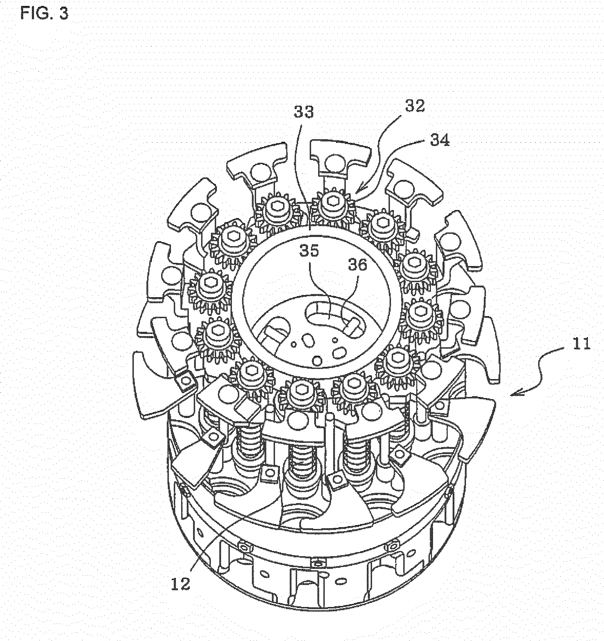

Also, multi-nozzle head 11 is provided with nozzle rotating gear mechanism 32 (refer to fig. 3) for transmitting rotational power of Q-axis gear 27 to each nozzle holder 12. Nozzle rotating gear mechanism 32 engages cylindrical gear 33 (tooth surfaces not shown) that is rotatably held concentrically at the upper section of multi-nozzle head 11 and small gear 34 that is respectively attached to each nozzle holder 12, and by rotating small gear 34 of each nozzle holder 12 by rotating cylindrical gear 33 by Q-axis gear 27 of head holding unit 21, each nozzle holder 12 rotates around the shaft center of each nozzle holder 12 and thus the orientation (angle) of each component picked up by each suction nozzle 13 held by each nozzle holder 12 is corrected.

As shown in fig. 3, in order to insert R axis 22 of head holding unit 21 into cylindrical gear 33, the inner diameter of the cylindrical gear 33 is formed slightly larger than the outer diameter of R axis 22. In positions inside cylindrical gear 33 on the upper surface of multi-nozzle head 11, multiple elongated holes 35 for inserting through each engaging member 31 of R axis 22 are formed at even intervals in a circumferential direction, and on one side of each elongated hole 35, pin to be engaged 36 (member to be engaged) that is engaged by the claw section of engaging member 31 is fixedly penetrating in the radial direction of multi-nozzle head 11. To the side of pin to be engaged 36 of each elongated hole 35, a gap is maintained so that engaging member 31 can pass by in the up/down direction.

A Z-axis driving mechanism (not shown) using Z-axis motor 37 (refer to fig. 6) as a driving source is assembled on head holding unit 21 in addition to R-axis driving mechanism 23 and Q-axis driving mechanism 26, and the configuration is such that nozzle holder 12 is lowered at the predetermined stopping position of the rotational path of nozzle holder 12 by the Z-axis driving mechanism.

On the other hand, as shown in figs. 4 and 5, single-nozzle head 38 is divided into attachment section 39 that is held on head holding unit 21 to be exchangeable with multi-nozzle head 11, and a single nozzle section 13' that is exchangeably held on attachment section 39. The holding configuration for holding attachment section 39 of single-nozzle head 38 on head holding unit 21 and the holding configuration for holding multi-nozzle head 11 on head holding unit 21 are shared. Accordingly, although not shown, on the upper surface of attachment section 39, multiple elongated holes for inserting through each engaging member 31 of R axis 22 are formed at even intervals in a circumferential direction, and on one side of each elongated hole, a pin to be engaged (member to be engaged) that is engaged by the claw section of engaging member 31 is fixedly penetrating in the radial direction of attachment section 39.

The component mounter is provided with a head loading section (not shown) on which multi-nozzle head 11 and attachment section 39 of single-nozzle head 38 for exchange are loaded. This head loading section is configured such that multiple types of multi-nozzle heads 11 and at least one type of attachment section 39 can be loaded. When attaching multi-nozzle head 11 or attachment section 39 loaded on this head loading section to head holding unit 21, R axis 22 of head holding unit 21 is inserted into cylindrical gear 33 and each engaging member 31 of R axis 22 is inserted into each elongated hole 35 of multi-nozzle head 11 or attachment section 39, and each engaging member 31 is pulled up and held while each engaging member 31 is engaged with pin to be engaged 36 in each elongated hole 35 by rotating R axis 22 by the rotation of R-axis gear 24.

Further, in the present embodiment, the holding configuration for holding nozzle section 13' in attachment section 39 of single-nozzle head 38 and the holding configuration for holding suction nozzle 13 in multi-nozzle head 11 is shared, such that suction nozzle 13 can be held in attachment section 39 as nozzle section 13'. Here, nozzle section 13' used on single-nozzle head 38 is not limited to suction nozzle 13 used on multi-nozzle head 11, and a newly manufactured nozzle section 13' for use as single nozzle head 38 may be used, that is, it is acceptable so long as suction nozzle 13 used on multi-nozzle head 11 is included in the various nozzle sections 13' used on single-nozzle head 38.

As shown in figs. 4 and 5, on the upper section of nozzle section 13' (suction nozzle 13), engagement pin 14 (engagement protruding section) is provided protruding in the diameter direction. With respect to this, an L-shaped or J-shaped engagement groove 16 (bayonet type engagement groove), into which each engaging pin 14 is inserted from below, is formed in engagement cylindrical section 15 that engages the upper section of nozzle section 13' (suction nozzle 13) in attachment section 39 and an engagement cylindrical section (not shown) that engages the upper section of suction nozzle 13 in nozzle holder 12. Further, in each of engagement cylindrical section 15 of attachment section 39 and the engagement cylindrical section nozzle holder 12, a cylindrical pressing member 17 is engaged to be capable of moving up and down, and the pressing member 17 is pushed down by spring 18 (spring).

A nozzle loading section (not shown in the figure) on which suction nozzles 13 and nozzle sections 13' for exchange are loaded is provided on the component mounter. This nozzle loading section is configured such that multiple types of suction nozzles 13 and nozzle sections 13' can be loaded in a state with rotation being stopped (a state in which engagement pin 14 is positioned in a predetermined direction). When attaching suction nozzle 13 or nozzle section 13' loaded on this nozzle loading section to nozzle holder 12 or attachment section 39, first, multi-nozzle head 11 or attachment section 39 of single-nozzle head 39 is moved above the nozzle loading section by head moving device 20 (refer to fig. 6), nozzle holder 12 or attachment section 39 to which suction nozzle 13 or nozzle section 13' is to be attached is positioned directly above the suction nozzle 13 or nozzle section 13', and inlet 16a of engagement groove 16 in engagement cylindrical section 15 of the nozzle holder 12 or attachment section 39 is entered into a state being positioned at engagement pin 14 of suction nozzle 13 or nozzle section 13'. In this state, multi-nozzle head 11 or attachment section 39 is lowered, and after engagement cylindrical section 15 of nozzle holder 12 or attachment section 39 is pushed into the upper section of suction nozzle 13 or nozzle section 13' and engagement pin 14 of suction nozzle 13 or nozzle section 13' is inserted into inlet 16a of engagement groove 16 in engagement cylindrical section 15, by rotating the nozzle holder 12 or attachment setion 39 in the engagement direction (the end direction of engagement groove 16), engagement pin 14 of suction nozzle 13 or nozzle section 13' is engaged with the V-shaped recess section of engagement groove 16 of the nozzle holder 12 or attachment section 39. This engaged state is kept by engagement pin 14 being pressed to the V-shaped recess section of engagement groove 16 by pressing member 17 by the spring force of spring 18. When suction nozzle 13 or nozzle section 13' is removed from nozzle holder 12 or attachment section 39, this may be done in the order reverse to the above, whereby suction nozzle 13 or nozzle section 13' removed from nozzle holder 12 or attachment section 39 is loaded on the nozzle loading section.

Control device 41 (refer to fig. 6) of the component mounter, according to a production program, controls head moving device 20, R-axis motor 25 of head holding unit 21, Q-axis motor 28, and Z-axis motor 37, and as well as controlling the operation for a component supplied from feeder 42 set in a component mounter to be picked up and mounted on a circuit board by section nozzle 13 or nozzle section 13', controls operation for multi-nozzle head 11 and attachment section 39 of single-nozzle head 38 to be attached to and detacted from head holding unit 21, and operation for suction nozzle 13 or nozzle section 13' to be attached to and detached from nozzle holder 12 of multi-nozzle head 11 or attachment section 39 of single-nozzle head 38.

With the component mounter of the embodiment described above, single-nozzle head 38 is divided into attachment section 39 held by head holding unit 21, and nozzle section 13', and the holding configuration of nozzle section 13' on attachment section 39, and the holding configuration of suction nozzle 13 on multi-nozzle head 11 are shared, therefore it is possible to use nozzle section 13' of single-nozzle head 38 as a suction nozzle 13 of multi-nozzle head 11. By this, various (different types of) single-nozzle heads 38 with different sizes and shapes of nozzle sections 13' (suction nozzles 13) can be provided at low cost, thus curtailing any increase in storage space required due to the increased quantity of various single-nozzle heads 38, and meeting the needs for low cost and reduced space.

Further, with the embodiment, it is possible to automate operation of attaching and detaching nozzle sections 13' and suction nozzles 13 to and from attachment section 39 of single-nozzle head 38 held on head holding unit 21, to automate exchange operation of multi-nozzle head 11 to and from head holding unit 21, to automate exchange operation of attachment section 39 of single-nozzle head 38 to and from head holding unit 21, thereby reducing the time required for exchange operation and improving operation efficiency of the component mounter.

Further, with the embodiment, because nozzle section 13' (suction nozzle 13) is held mechanically in attachment section 39 (nozzle holder 12) by the engagement of engagement pin 14 at the nozzle section 13' (suction nozzle 13) side and engagement groove 16 at the attachment section 39 (nozzle holder 12) side, positional deviation or dropping of nozzle section 13' (suction nozzle 13) due to the inertia force can be prevented even if single-nozzle head 38 (multi-nozzle head 11) held on head holding unit 21 is moved at a high speed. However, note that, for the present invention, it is also acceptable for nozzle section 13' (suction nozzle 13) to be held in attachment section 39 (nozzle holder 12) using a plunger or plate spring.

Also, because single-nozzle head 38 (multi-nozzle head 11) is held mechanically on head holding unit 21 by the engagement of pin to be engaged 36 at the side of the attachment section 39 of single-nozzle head 38 (at the multi-nozzle head 11 side) and engaging member 31 at the head holding unit 21 side, positional deviation or dropping of single-nozzle head 38 (multi-nozzle head 11) due to the inertia force can be prevented even if single-nozzle head 38 (multi-nozzle head 11) held on head holding unit 21 is moved at a high speed. However, for the present invention, it is also acceptable for single-nozzle head 38 (multi-nozzle head 11) to be picked up and held on head holding unit 21 using negative pressure suction force.

Furthermore, the present invention is not limited to the above embodiments, and various embodiments with changes that do not extend beyond the scope of the invention are possible such as it is acceptable to appropriately change, for example, the configuration that engages and holds attachment section 39 of single-nozzle head 38 (multi-nozzle head 11) on head holding unit 21, or the configuration that engages and holds nozzle section 13' (suction nozzle 13) in attachment section 39 (nozzle holder 12), or to have a configuration such that a multi-nozzle head that does not rotate is held by head holding unit 21.

### Reference Signs List

11: multi-nozzle head; 12: nozzle holder; 13: suction nozzle; 13': nozzle section; 14: engagement pin (engagement protruding section); 15: engagement cylindrical section; 16: engagement groove; 17: pressing member; 18: spring; 20: head moving device; 21: head holding unit; 22: R axis; 23: R-axis driving mechanism (head rotating mechanism); 24: R-axis gear; 25: R-axis motor; 26: Q-axis driving mechanism (nozzle rotating mechanism); 27: Q-axis gear; 28: Q-axis motor; 31: engaging member; 32: nozzle rotating gear mechanism; 33: cylindrical gear; 34: small gear; 35: elongated hole; 36: pin to be engaged (member to be engaged); 37: Z-axis motor; 38: single-nozzle head; 39: attachment section; 41: control device; 42: feeder

## Claims

1. A component mounter comprising:
a head holding unit (21) configured to exchangeably hold either a multi-nozzle head (11) that is configured to exchangeably hold multiple suction nozzles (13) that are configured to pick up a component or a single-nozzle head (38) that is configured to hold a single nozzle section (13'), and
a head moving device (20) configured to move the head holding unit (21), **characterized in that** the single-nozzle head (38) is configured from an attachment section (39) that is exchangeable with the multi-nozzle head (11) on the head holding unit (21), and the single nozzle section (13') that is exchangeably held on the attachment section (39) and picks up the component, and
a holding configuration of the single nozzle section (13') on the attachment section (39) and a holding configuration of the suction nozzle (13) on the multi-nozzle head (11) are shared, such that the suction nozzle (13) of the multi-nozzle head (11) can be held on the attachment section (39) of the single-nozzle head (38) as the single nozzle section (13') and the single nozzle section (13') of the single-nozzle head (38) can be held on the multi-nozzle head (11) as one of its suction nozzles (13).

2. The component mounter according to claim 1, further comprising:
a control device (41) configured to control operation of the head moving device (20) so as to attach and detach the nozzle section (13') or the suction nozzle (13) to and from the attachment section (39) held by the head holding unit (21).

3. The component mounter according to claim 2, wherein
the control device (41) controls operation of the head moving device (20) so as to attach and detach the multi-nozzle head (11) or the attachment section (39) to and from the head holding unit (21).

4. The component mounter according to any one of the claims 1 to 3, wherein
a nozzle holder (12) for holding the suction nozzle (13) is lowerably held on the multi-nozzle head (11);
an engagement protruding section (14) is provided protruding to a side on an upper section of the suction nozzle (13) and on an upper section of the nozzle section (13');
an engagement groove (16) with an inverted L shape or inverted J shape into which the engagement protruding section (14) is inserted from below is formed in an engagement cylindrical section (15) which engages the upper section of the suction nozzle (13) in the nozzle holder (12) and in an engagement cylindrical section (15) which engages the upper section of the nozzle section (13') in the attachment section (39); and
a spring (18) to maintain the state in which the respective engagement protruding sections (14) are engaged with the respective engagement grooves (16) is provided in the nozzle holder (12) and the attachment section (39).

## Patentansprüche

1. Bauteil-Montagevorrichtung, die umfasst:
eine Einheit (21) zum Halten eines Kopfes, die so eingerichtet ist, dass sie entweder einen Mehrfachdüsen-Kopf (11), der so eingerichtet ist, dass er mehrere Saugdüsen (13), die zum Aufnehmen eines Bauteils eingerichtet sind, austauschbar hält, oder einen Einfachdüsen-Kopf (38), der so eingerichtet ist, dass er einen Einzel-Düsen-Teilabschnitt (13') hält, austauschbar hält, sowie
eine Einrichtung (20) zum Bewegen des Kopfes, die so eingerichtet ist, dass sie die Einheit (21) zum Halten eines Kopfes bewegt,
**dadurch gekennzeichnet, dass**
der Einfachdüsen-Kopf (38) aus einem Anbringungs-Teilabschnitt (39), der gegen den Mehrfachdüsen-Kopf (11) an der Einheit (21) zum Halten eines Kopfes ausgetauscht werden kann, und dem Einzel-Düsen-Teilabschnitt (13') besteht, der austauschbar an dem Anbringungs-Teilabschnitt (39) gehalten wird und das Bauteil aufnimmt, und
eine Konstruktion zum Halten des Einzel-Düsen-Teilabschnitts (13') an dem Anbringungs-Teilabschnitt (39) sowie eine Konstruktion zum Halten der Saugdüse (13) an dem Mehrfachdüsen-Kopf (11) geteilt genutzt werden, so dass die Saugdüse (13) des Mehrfachdüsen-Kopfes (11) als der Einzel-Düsen-Teilabschnitt (13') an dem Anbringungs-Teilabschnitt (39) des Einfachdüsen-Kopfes (38) gehalten werden kann und der Einzel-Düsen-Teilabschnitt (13') des Einfachdüsen-Kopfes (38) an dem Mehrfachdüsen-Kopf (11) als eine seiner Saugdüsen (13) gehalten werden kann.

2. Bauteil-Montagevorrichtung nach Anspruch 1, die des Weiteren umfasst:
eine Steuerungs-Einrichtung (41), die so eingerichtet ist, dass sie Funktion der Einrichtung (20) zum Bewegen des Kopfes so steuert, dass der Düsen-Teilabschnitt (13') oder die Saugdüse (13) an dem von der Einheit (21) zum Halten eines Kopfes gehaltenen Anbringungs-Teilabschnitt (39) angebracht und von ihm entfernt wird.

3. Bauteil-Montagevorrichtung nach Anspruch 2, wobei
die Steuerungs-Einrichtung (41) Funktion der Einrichtung (20) zum Bewegen des Kopfes so steuert, dass der Mehrfachdüsen-Kopf (11) oder der Anbringungs-Teilabschnitt (39) an der Einheit (21) zum Halten eines Kopfes angebracht und von ihr entfernt wird.

4. Bauteil-Montagevorrichtung nach einem der Ansprüche 1 bis 3, wobei
ein Düsen-Halter (12) zum Halten der Saugdüse (13) absenkbar an dem Mehrfachdüsen-Kopf (11) gehalten wird;
ein vorstehender Eingriffs-Teilabschnitt (14) vorstehend an einer Seite an einem oberen Teilabschnitt der Saugdüse (13) und an einem oberen Teilabschnitt des Düsen-Teilabschnitts (13') angeordnet ist;
eine Eingriffs-Nut (16) in Form eines umgekehrten "L" oder eines umgekehrten "J", in die der vorstehende Eingriffs-Teilabschnitt (14) von unten eingeführt wird, in einem zylindrischen Eingriffs-Teilabschnitt (15), der mit dem oberen Teilabschnitt der Saugdüse (13) in dem Düsen-Halter (12) in Eingriff kommt, sowie in einem zylindrischen Eingriffs-Teilabschnitt (15) ausgebildet ist, der mit dem oberen Teilabschnitt des Düsen-Teilabschnitts (13') in dem Anbringungs-Teilabschnitt (39) in Eingriff kommt; und
eine Feder (18), die den Zustand aufrechterhält, in dem die jeweiligen vorstehenden Eingriffs-Teilabschnitte (14) mit den jeweiligen Eingriffs-Nuten (16) in Eingriff sind, in dem Düsen-Halter (12) sowie dem Anbringungs-Teilabschnitt (39) vorhanden ist.

## Revendications

1. Dispositif de montage de composant comprenant :
une unité de support de tête (21) configurée pour supporter de manière échangeable soit une tête multibuse (11) configurée pour supporter de manière échangeable de multiples buses de succion (13) qui sont configurées pour saisir un composant, soit une tête monobuse (38) configurée pour supporter une section monobuse (13'), et
un dispositif de déplacement de tête (20) configuré pour déplacer l'unité de support de tête (21), **caractérisé en ce que**
la tête monobuse (38) est configurée par une section d'attachement (39) qui est échangeable avec la tête multibuse (11) sur l'unité de support de tête (21), et par la section monobuse (13') qui est supportée de manière échangeable sur la section d'attachement (39) et saisit le composant, et
une configuration de support de la section monobuse (13') sur la section d'attachement (39) et une configuration de support de la buse de succion (13) sur la tête multibuse (11) sont partagées, de telle sorte que la buse de succion (13) de la tête multibuse (11) peut être supportée sur la section d'attachement (39) de la tête monobuse (38) comme la section monobuse (13') et la section monobuse (13') de la tête monobuse (38) peut être supportée sur la tête multibuse (11) comme l'une de ses buses de succion (13).

2. Dispositif de montage de composant selon la revendication 1, comprenant en outre :
un dispositif de commande (41) configuré pour contrôler le fonctionnement du dispositif de déplacement de tête (20) de manière à attacher et détacher la section de buse (13') ou la buse de succion (13) sur la section d'attachement (39) supportée par l'unité de support de tête (21) .

3. Dispositif de montage de composant selon la revendication 2, dans lequel
le dispositif de commande (41) contrôle le fonctionnement du dispositif de déplacement de tête (20) de manière à attacher et détacher la tête multibuse (11) ou la section d'attachement (39) sur l'unité de support de tête (21) .

4. Dispositif de montage de composant selon l'une quelconque des revendications 1 à 3, dans lequel
un support de buse (12) pour supporter la buse de succion (13) est supporté de manière abaissable sur la tête multibuse (11) ;
une section protubérante d'engagement (14) est pourvue de manière à ressortir vers un côté sur une section supérieure de la buse de succion (13) et sur une section supérieure de la section de buse (13') ;
une rainure d'engagement (16) avec une forme de L inversé ou une forme de J inversé, dans laquelle la section protubérante d'engagement (14) est insérée par le bas, est formée dans une section cylindrique d'engagement (15) qui engage la section supérieure de la buse de succion (13) dans le support de buse (12) et dans une section cylindrique d'engagement (15) qui engage la section supérieure de la section de buse (13') dans la section d'attachement (39) ; et
un ressort (18) pour maintenir l'état dans lequel les sections protubérantes d'engagement respectives (14) sont engagées avec les rainures d'engagement respectives (16) est pourvu dans le support de buse (12) et la section d'attachement (39).
